# EUROPEAN PATENT APPLICATION

(11) **EP 4 488 223 A1**
(43) Date of publication of application: **08.01.2025**
(21) Application number: 23382698.1
(22) Date of filing: 07.07.2023
(51) Int. Cl.: B81B 3/00

(54) **A FLEXOELECTRIC MATERIAL COMPRISING WATER ICE AND A WATER-SOLUBLE COMPOUND**

(71) Applicant: Fundació Institut Català de Nanociència i Nanotecnologia (ICN2), 08193 Bellaterra (ES); Institució Catalana De Recerca I Estudis Avançats (ICREA), 08010 Barcelona (ES)
(72) Inventor: CATALAN BERNABÉ, Gustau, 08172 SANT CUGAT DEL VALLÈS (ES); WEN, Xin, 08193 CERDANYOLA DEL VALLÈS (ES)
(74) Representative: ZBM Patents - Zea, Barlocci & Markvardsen

(57) **Abstract**

It relates to a flexoelectric material comprising water ice and a water-soluble ionizable compound, and to a flexoelectric device comprising the said flexoelectric material. It also relates to the use of a material comprising water ice and a water-soluble ionizable compound as a flexoelectric material, and to a method for generating electricity comprising the step of applying a strain gradient to the flexoelectric material of a flexoelectric device as defined herein.

## Description

### Technical Field

The present invention relates to the field of flexoelectric materials and particularly to flexoelectric devices comprising flexoelectric materials that generate a voltage when a strain gradient is applied.

### Background Art

Piezoelectricity is the property of a material by which electricity or electric polarization is produced as a result of applying mechanical strain. Piezoelectricity has been studied and utilized for many decades in useful technologies such as ultrasound scanners or pressure sensors. Lead-based ferroelectrics such as lead zirconate titanate (PZT) are the most widely exploited and extensively used piezoelectric materials, but they contain a toxic element (lead), and there is a strong regulatory incentive to progressively get rid of all lead content in electronic devices.

By contrast, a close relative of piezoelectricity, flexoelectricity has been relatively neglected until very recently. Flexoelectricity is a physical property of materials (dielectric insulators mainly) whereby they generate a voltage when they are bent, while converse flexoelectricity is the inverse mechanism, whereby materials bend when they are subject to a voltage. Thus, in flexoelectric materials, polarization is induced by a strain gradient rather than by a homogeneous strain.

All flexoelectric devices have two electrodes and a dielectric material inserted between them. When subject to an inhomogeneous deformation (strain gradient), such as bending, the dielectric material will polarize and generate a charge density at its surface. The role of the electrodes is to collect this charge.

The key disadvantage of flexoelectricity when compared with piezoelectricity as a mechanism for converting deformation into electricity is that the amount of charge that can be generated by pure flexoelectric means is generally small compared to that which can be generated by piezoelectric means.

Typical flexoelectric coefficients are of the order of a few nC/m (nano-Coulomb per meter), sometimes even smaller. The largest flexoelectric coefficients have been measured in barium titanate and barium-strontium titanate and are of the order of a few µC/m (micro-Coulomb per meter). A piezoelectric bimorph (i.e., an assembly of two piezoelectric crystals cemented together so that an applied voltage causes one to expand and the other to contract, converting electrical signals into mechanical energy) subject to the same strain gradients as a "normal" flexoelectric will normally generate much more charge.

Ice, formed by hydrogen bonding of water molecules, is one of the most widespread and abundant solids on earth. Manifesting itself as snowflakes, frosts, and glaciers in nature, ice plays an essential role in geology, meteorology, and astronomy. Moreover, liquid water itself is ice-like when nano-confined or at the interface with solids, which renders the physics of ice also relevant to life science. Despite the massive body of knowledge on ice, new phases and anomalous properties continue to be discovered, suggesting there is still plenty of potential for new phenomena and applications.

Ice is not generally considered as a functional material, and in particular it has no electromechanical transducer applications, as it is not piezoelectric. In contrast to the oxygen atoms, which in ordinary ice are arranged in a hexagonal lattice, the hydrogen atoms do not exhibit long-range order. This "proton disorder" feature leads to randomly oriented water dipoles and thus, despite the polar nature of each individual water molecule, ice itself is not macroscopically piezoelectric as local polarization changes induced by homogenous deformations average out.

But, while symmetry considerations mean that ice cannot be piezoelectric, there is no symmetry restriction to flexoelectricity. We have recently measured the flexoelectric coefficient of ice, and found it to be rather low (1~3 nC/m).

Thus, although the widespread availability of ice would make it interesting for flexoelectric devices, there is still a need to obtain higher flexoelectric coefficients for practical applications.

### Summary of Invention

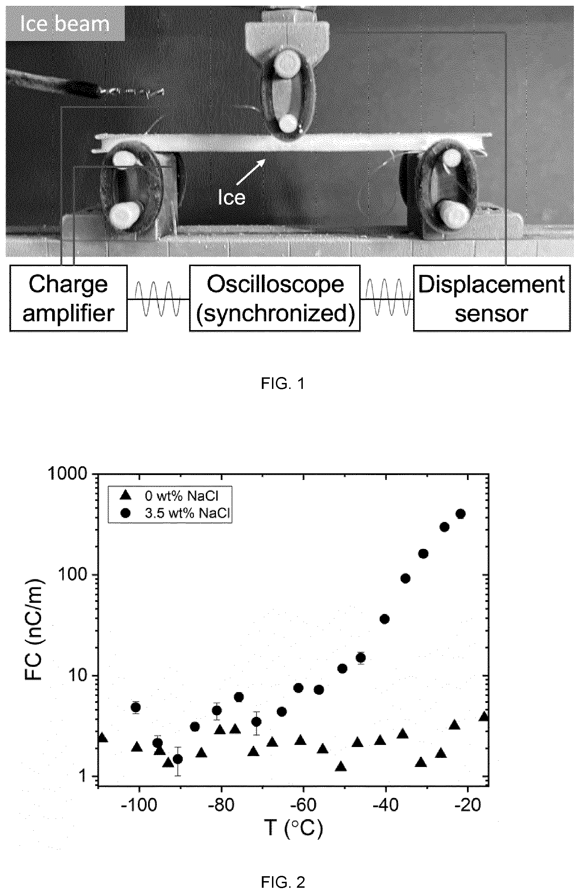

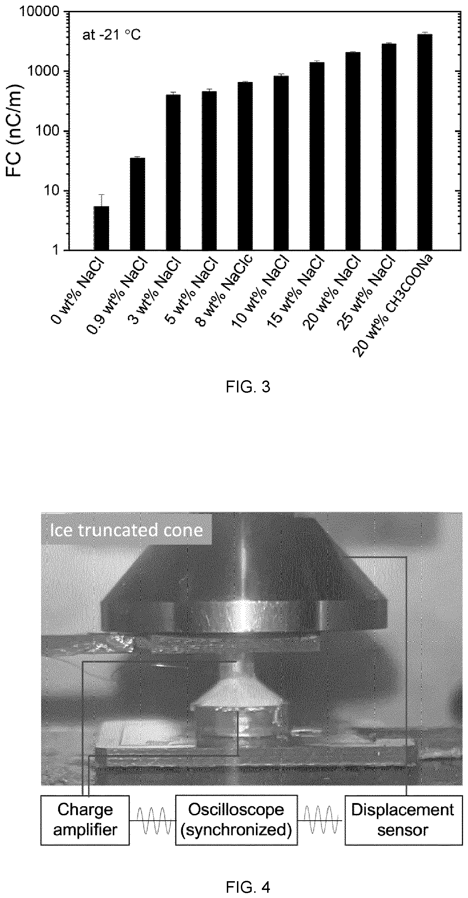

As mentioned above, the flexoelectric coefficient of water ice is rather low. In particular, it remains relatively constant in the range from 1 to 3 nC/m at temperatures from -110 to -20 °C (see the triangle symbols in FIG. 2). The present inventors have found that when ice is doped with a water-soluble ionizable compound the performance of the material is significantly improved. As shown in the examples below, the flexoelectric coefficient of ice containing 3.5 wt% of NaCl steadily increases at temperatures above -70 °C and can reach as high as -400 nC/m at -21 °C, which is over two orders of magnitude larger with respect to pure ice (see the circles in FIG. 2). Doping more NaCl into ice leads to larger flexoelectric enhancement. The flexoelectric coefficient of ice doped with 25 wt% of NaCl reaches 2900 nC/m at -21 °C, which is over three orders of magnitude larger than that of pure ice (see FIG. 3).

The flexoelectric enhancement in ice caused by doping with water-soluble ionizable compounds was unexpected in view of the prior art, because water-soluble ionizable compounds, in particular salts such as NaCl, generally have a very small flexoelectric coefficients, about 0.001 nC/m, which is three to four orders of magnitude smaller than that of ice. A skilled person in the art would consider that, to enhance flexoelectricity through doping, the dopant itself should generally have a flexoelectric coefficient larger than the matrix materials. Therefore, the natural speculation would be that NaCl-doped ice is a composite of pure ice and solid interstitial salt, with the latter making no significant impact on the total flexoelectricity, as in fact happens below -70 °C.

Without wishing to be bound by any particular theory, it is believed that the grain boundaries of polycrystalline ice host quasi-liquid layers (i.e., naturally nanofluidic channels), which can generate streaming ionic current in response to the application of a stress (strain) gradient (aka "flexo-streaming effect"), thereby dramatically increasing the natural flexoelectric potential of pure ice. To the best knowledge of the inventors, this new mechanism of enhancing ice flexoelectricity has not ever been reported in the fields of both ice physics and flexoelectric research.

The results herein indicate that water ice doped with a water-soluble ionizable compound can be used to develop low-cost sensing and energy-harvesting devices made in-situ in low-temperature environments, for example by both arctic oceans.

Additionally, as shown in the examples, the inventors have also found that the flexoelectric material of the invention is capable to provide piezoelectric-like effects that arise from the flexoelectric effects of the material.

Thus, in a first aspect, the present invention provides a flexoelectric material comprising water ice and a water-soluble ionizable compound.

In a second aspect, the invention provides a flexoelectric device comprising a flexoelectric material as defined in the first aspect.

In a third aspect, the invention provides the use of a material comprising water ice and a water-soluble ionizable compound as a flexoelectric material.

In a fourth aspect, the invention provides a method for generating electricity comprising the step of applying a strain gradient to the flexoelectric material of a flexoelectric device as defined in the second aspect.

### Brief Description of Drawings

FIG. 1 shows an ice capacitor subjected to oscillating three-point bending deformation for the flexoelectric measurement.
FIG. 2 shows the effective flexoelectric coefficient as a function of temperature for pure ice and 3.5wt% NaCl-doped ice.
FIG. 3 shows the effective flexoelectric coefficient of ice at different doping conditions at -21 °C.
FIG. 4 shows an ice truncated cone subjected to oscillating compression for the piezoelectric measurement.
FIG. 5 shows the apparent piezoelectric coefficient as a function of temperature for 25wt% NaCl-doped ice.
FIG. 6 shows the electrodes preparation and piezoelectric characterization for the integrated 36 ice truncated cones.

### Detailed description of the invention

All terms as used herein in this application, unless otherwise stated, shall be understood in their ordinary meaning as known in the art. Other more specific definitions for certain terms as used in the present application are as set forth below and are intended to apply uniformly through-out the specification and claims unless an otherwise expressly set out definition provides a broader definition.

The term "about" or "around" as used herein refers to a range of values ± 10% of a specified value. For example, the expression "about 10" or "around 10" includes ± 10% of 10, i.e., from 9 to 11.

For the purposes of the present invention, any ranges given include both the lower and the upper endpoints of the range. Ranges given, such as weight, temperature, time, and the like, should be considered approximate, unless specifically stated.

The term "doped", as used herein, refers to a material (i.e., water ice) which contains within it an amount of a water-soluble ionizable compound (dopant) and as a result shows modified properties.

As mentioned above, a first aspect of the invention relates to a material comprising a flexoelectric material comprising water ice and a water-soluble ionizable compound. This aspect can also be formulated as flexoelectric material comprising water ice doped with a water-soluble ionizable compound.

For the purposes of the invention, the term "water ice" refers to water which has been frozen into a solid state typically at temperatures below 0 °C.

As mentioned above, when water ice is doped with a water-soluble ionizable compound the flexoelectric coefficient steadily increases in particular at temperatures above -70 °C. To measure the flexoelectricity of ice, a dynamic mechanical analyzer (DMA) may be used to deliver an oscillating three-point bending deformation to the ice capacitor as shown in the examples (FIG. 1). The recorded bending deformation and the bending-induced charge are used to calculate the flexoelectric coefficient.

In one embodiment, optionally in combination with one or more features of the various embodiments described above or below throughout all the description, the water-soluble ionizable compound is present in the flexoelectric material at a concentration from 0.1 to 67 wt%, more particularly from 0.1 to 33 wt%, even more particularly from 0.4 to 25 wt%, with respect to the total weight of the material.

In another embodiment, optionally in combination with one or more features of the various embodiments described above or below throughout all the description, the water-soluble ionizable compound is present in the flexoelectric material at a concentration from about 0.1 wt%, about 0.2 wt%, about 0.3 wt%, about 0.4 wt%, about 0.5 wt%, about 0.9 wt%, about 1 wt%, about 2 wt%, about 3 wt%, about 3.5 wt%, about 4 wt%, about 5 wt%, about 6 wt%, about 7 wt%, about 8 wt%, about 9 wt%, about 10 wt%, about 11 wt%, about 12 wt%, about 13 wt%, about 14 wt%, about 15 wt%, about 16 wt%, about 17 wt%, about 18 wt%, about 19 wt%, about 20 wt%, about 21 wt%, about 22 wt%, about 23 wt%, about 24 wt%, about 25 wt%, about 26 wt%, about 27 wt%, about 28 wt%, about 29 wt%, about 30 wt%, about 35 wt%, about 40 wt%, about 45 wt%, about 50 wt%, about 55 wt%, about 60 wt%, about 55 wt%, or about 67 wt%, with respect to the total weight of the material.

For the purposes of the invention, the term "ionizable compound" refers to a compound having at least one ionizable site in its molecular structure. Such ionizable compound is not necessarily ionized, rather it may be in either ionized (i.e., it may contain anions and cations) or in un-ionized form.

According to one embodiment, optionally in combination with one or more features of the various embodiments described above or below throughout all the description, the water-soluble ionizable compound is selected from the group consisting of a base, an acid, a salt, and mixtures thereof.

Non-limiting examples of bases that may be used include inorganic bases such as NH₃, alkali metal hydroxides (such as e.g., NaOH, KOH, LiOH, RbOH, CsOH) and alkaline earth metal hydroxides (such as e.g., Ca(OH)₂, Ba(OH)₂, Sr(OH)₂).

Non-limiting examples of acids that may be used include inorganic acids such as HCl, HF, HBr, HI, HClO₄, HFO, H₂SO₄, HSOaF, HNO₃, and H₃PO₄, and organic acids such as sulfonic acids, carboxylic acids, and halogenated carboxylic acids (e.g., CH₃SO₃H, CF₃SO₃H, CH₃COOH, C₆H₈O₇, HCOOH, CH₂FCO₂H, CF₃CO₂H).

Non-limiting examples of salts that may be used include inorganic salts such as alkali metal salts (e.g., NaCl, KCI, LiCI), organic salts such as acetates, citrates, and carbonates of alkali or alkaline earth metals (e.g. CH₃COONa, K₃C₆H₅O₇, LiC₂H₃O₂).

In one embodiment, optionally in combination with one or more features of the various embodiments described above or below throughout all the description, the water-soluble ionizable compound is a salt, more particularly selected from the group consisting of an inorganic salt, an organic salt, and mixtures thereof.

In another embodiment, optionally in combination with one or more features of the various embodiments described above or below throughout all the description, the water-soluble ionizable compound is an inorganic salt, particularly an alkali metal salt, even more particularly selected from the group consisting of NaCl, KCI, and LiCl, even more particularly NaCl.

In another embodiment, optionally in combination with one or more features of the various embodiments described above or below throughout all the description, the water-soluble ionizable compound is an organic salt, more particularly the organic salt is selected from the group consisting of acetates, citrates, and carbonates of alkali or alkaline earth metals, even more particularly the organic salt is an acetate of an alkali or alkaline earth metal, and even more particularly the organic salt is sodium acetate.

In another embodiment, optionally in combination with one or more features of the various embodiments described above or below throughout all the description, the flexoelectric material has a temperature from -273 to -0.5 °C, more particularly from -273 to -5 °C, and even more particularly from -70 to -20 °C.

In another embodiment, optionally in combination with one or more features of the various embodiments described above or below throughout all the description, the water-soluble ionizable compound is a base, more particularly selected from the group consisting of NH₃, an alkali metal hydroxide, an alkaline earth metal hydroxide, and mixtures thereof.

In another embodiment, optionally in combination with one or more features of the various embodiments described above or below throughout all the description, the water-soluble ionizable compound is an acid, more particularly selected from the group consisting of an inorganic acid, and organic acid, and mixtures thereof.

In another embodiment, optionally in combination with one or more features of the various embodiments described above or below throughout all the description, the flexoelectric material has a temperature from about -273 °C, about -200 °C, about -150 °C, about -120 °C, about -110 °C, about -100 °C, about -90 °C, about -80 °C, about -70 °C, about -65 °C, about -60 °C, about -55 °C, about -50 °C, about -45 °C, about -40 °C, about -35 °C, about -30 °C, about -25 °C, about -20 °C, about -15 °C, about -10 °C, about -5 °C, about -0.5 °C.

The flexoelectric material of the invention may be present in nature or can be conveniently prepared by a simple process.

Thus, in one embodiment, optionally in combination with one or more features of the various embodiments described above or below throughout all the description, the flexoelectric material may be found in nature.

In another embodiment, optionally in combination with one or more features of the various embodiments described above or below throughout all the description, the flexoelectric material of the invention is obtainable by a process comprising the steps of:
(a) dissolving a water-soluble ionizable compound in water; and
(b) freezing the water with the dissolved water-soluble ionizable compound.

It also forms part of the invention a process for the preparation of the flexoelectric material of the invention which comprises the steps of:
(a) dissolving a water-soluble ionizable compound in water; and
(b) freezing the water with the dissolved water-soluble ionizable compound.

The expression "obtainable by" is used herein for defining the material or the precursor material of the invention by their preparation process and refer to the product that can be obtained through the preparation process disclosed herein. For the purposes of the invention, the expressions "obtainable", "obtained" and similar equivalent expressions are used interchangeably and, in any case, the expression "obtainable" encompasses the expression "obtained".

Step a) may be carried out at room temperature (about 20-25 °C) and optionally under stirring.

Step b) may be carried out at any convenient temperature equal to or lower than 0 °C.

In a second aspect, the invention also relates to a flexoelectric device comprising a flexoelectric material as defined herein.

According to one embodiment, optionally in combination with one or more features of the various embodiments described above or below throughout all the description, in the flexoelectric device, the flexoelectric material is arranged between a first electrically conductive substrate and a second electrically conductive substrate, and the flexoelectric material is capable of generating a voltage between the two electrically conductive substrates when a strain gradient is applied.

For the purposes of the invention the electrically conductive substrates may be metal plates, electrodes, or any other electrically conductive materials.

In one embodiment, optionally in combination with one or more features of the various embodiments described above or below throughout all the description, the flexoelectric material comprises at least one structure in a shape selected form the group consisting of a cantilever, a parallel-plate beam, a truncated cone, a truncated pyramid, and a cylinder.

The shaped structures may be conveniently fabricated using tape casting techniques.

In one embodiment, optionally in combination with one or more features of the various embodiments described above or below throughout all the description, the electrically conductive substrates are deposited at positions so as to receive the flexoelectric signal generated by the bending induced stress gradient, more particularly the electrically conductive substrates are proximate, particularly adjacent, the regions of maximum stress gradient.

According to one embodiment, optionally in combination with one or more features of the various embodiments described above or below throughout all the description, the flexoelectric material is formed by a plurality of truncated cones.

In another embodiment, optionally in combination with one or more features of the various embodiments described above or below throughout all the description, the flexoelectric device is selected from the group consisting of a sensor, an actuator, and a transducer.

A third aspect of the invention relates to the use of a material comprising water ice and a water-soluble ionizable compound as a flexoelectric material.

The device of the invention can be used in applications such as energy harvesting, sensing cracks in the ice, or monitoring permafrost for example.

A fourth aspect of the invention relates to a method for generating electricity comprising the step of applying a strain gradient to the flexoelectric material of a flexoelectric device as defined herein.

Throughout the description and claims the word "comprise" and variations of the word, are not intended to exclude other technical features, additives, components, or steps. Furthermore, the word "comprise" encompasses the case of "consisting of". Additional objects, advantages and features of the invention will become apparent to those skilled in the art upon examination of the description or may be learned by practice of the invention. The following examples and drawings are provided by way of illustration, and they are not intended to be limiting of the present invention. Reference signs related to drawings and placed in parentheses in a claim, are solely for attempting to increase the intelligibility of the claim, and shall not be construed as limiting the scope of the claim. Furthermore, the present invention covers all possible combinations of particular and preferred embodiments described herein.

### Examples

### Example 1

To measure the flexoelectricity of ice, a dynamic mechanical analyzer (DMA) was used to deliver an oscillating three-point bending deformation to the ice capacitor (FIG. 1). The recorded bending deformation and the bending-induced charge are used to calculate the flexoelectric coefficient. FIG. 2 shows the measured flexoelectric coefficient for pure ice (made from pure water) and salty ice (made from water with 3.5 wt% NaCl) as a function of temperature. It was found that at temperatures above -70 °C, the flexoelectric coefficient increased by orders of magnitude, reaching up to -400 nC/m around the eutectic temperature (-21 °C), over two orders of magnitude larger than that of pure ice. FIG. 3 shows that the flexoelectricity enhancement is positively related to the doping concentration of NaCl at different concentrations. The flexoelectric coefficient of ice doped with 25 wt% of NaCl reached 2900 nC/m at -21 °C, which is over three orders of magnitude larger than that of pure ice. FIG. 3 also shows that doping CH₃COONa, instead of NaCl, into ice can enhance flexoelectricity significantly (4170 nC/m).

### Example 2

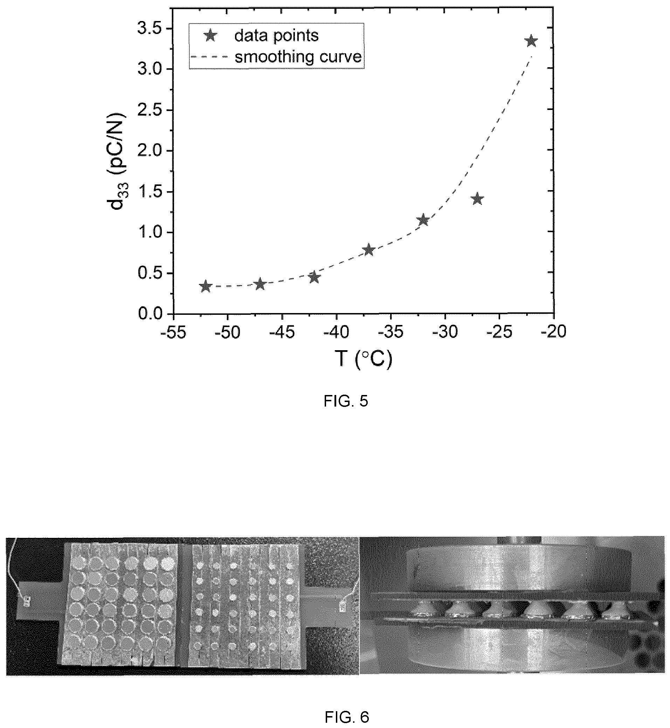

Based on the NaCl-induced flexoelectric enhancement, a "piezoelectric" ice device as shown in FIG. 4 was fabricated. Applying compressing force on a truncated ice cone can induce non-uniform deformation (strain gradient), and consequently electric polarization via the flexoelectric effect of ice. The experiments on ice (with 25wt% NaCl) showed that its apparent piezoelectric coefficient d₃₃ was around 3.3 pC/N at -21 °C (FIG. 5), comparable with that of quartz. This device was further integrated to amplify the electric output, as shown in FIG.6. These results suggest the interesting possibility of developing cheap sensing and energy-harvesting devices made in-situ in low-temperature environments by the sea.

## Claims

1. A flexoelectric material comprising water ice and a water-soluble compound.

2. The flexoelectric material according to claim 1, wherein the water-soluble ionizable compound is present at a concentration from 0.1 to 67 wt % with respect to the total weight of the material.

3. The flexoelectric material according to any one of claims 1-2, wherein the water-soluble ionizable compound is present at a concentration from 0.4 to 25 wt % with respect to the total weight of the material.

4. The flexoelectric material according to any one of claims 1-3, wherein the water-soluble ionizable compound is selected from a base, an acid, and a salt.

5. The flexoelectric material according to claim 4, wherein the salt is selected from the group consisting of an inorganic salt, an organic salt, and mixtures thereof.

6. The flexoelectric material according to claim 5, wherein the inorganic salt is NaCl.

7. The flexoelectric material according to any one of claims 1-6, which has a temperature from -273 to -0.5 °C; particularly from -70 to -20 °C.

8. The flexoelectric material according to any one of claims 1-7, which is obtainable by a process comprising the steps of:
(a) dissolving a water-soluble ionizable compound in water; and
(b) freezing the water with the dissolved water-soluble ionizable compound.

9. A flexoelectric device comprising a flexoelectric material as defined in any one of claims 1-8.

10. The flexoelectric device according to claim 9, wherein the flexoelectric material is arranged between a first electrically conductive substrate and a second electrically conducting substrate, and the flexoelectric material is capable of generating a voltage between the two electrically conductive substrates when a strain gradient is applied.

11. The flexoelectric device according to claim 9 or 10, wherein the flexoelectric material comprises at least one structure in a shape selected form the group consisting of a cantilever, a parallel-plate beam, a truncated cone, a truncated pyramid, and a cylinder.

12. The flexoelectric device according to any one of claims 9-11, wherein the flexoelectric material is formed by a plurality of truncated cones.

13. The flexoelectric device according to any one of claims 9-12, wherein the device is selected from the group consisting of a sensor, an actuator, and a transducer.

14. Use of a material comprising water ice and a water-soluble ionizable compound as a flexoelectric material.

15. A method for generating electricity comprising the step of applying a strain gradient to the flexoelectric material of a flexoelectric device as defined in any one of claims 9-13.
